Europäisches Patentamt

European Patent Office

Office européen des brevets

(11) Numéro de publication: **0 354 859 B1**

# FASCICULE DE BREVET EUROPEEN

(45) Date de publication de fascicule du brevet: **22.09.93**

(51) Int. Cl.5: **H01L 27/10**, H01L 29/788, G11C 17/00

(21) Numéro de dépôt: **89420288.6**

(22) Date de dépôt: **31.07.89**

(54) **Mémoire de type eprom à haute densité d'intégration avec une organisation en damier et un facteur de couplage amélioré.**

(30) Priorité: **11.08.88 FR 8810964**

(43) Date de publication de la demande:
**14.02.90 Bulletin 90/07**

(45) Mention de la délivrance du brevet:
**22.09.93 Bulletin 93/38**

(84) Etats contractants désignés:
**DE FR GB IT NL**

(56) Documents cités:
**EP-A- 0 040 251**
**FR-A- 2 296 914**

**PATENT ABSTRACTS OF JAPAN, vol. 7, no. 174 (E-190)[1319], 2 octobre 1983, page 4 E 190; & JP-A-58 78 467**

(73) Titulaire: **SGS-THOMSON MICROELECTRO-NICS S.A.**
**7, Avenue Galliéni**
**F-94250 Gentilly(FR)**

(72) Inventeur: **Bergemont, Albert**
**25, Chemin Pré Morin**
**F-38700 Corenc(FR)**

(74) Mandataire: **de Beaumont, Michel**
**1bis, rue Champollion**
**F-38000 Grenoble (FR)**

## Description

La présente invention concerne les mémoires à semiconducteur, et plus particulièrement les mémoires non-volatiles électriquement programmables, plus couramment appelées mémoires EPROM ; la fabrication des mémoires à grille flottante est plus précisément concernée.

Pour obtenir des mémoires de grande capacité de stockage, par exemple des mémoires capables de stocker jusqu'à 16 mégabits, on doit réduire le plus possible la dimension de chacune des cellules constituant la mémoire.

Mais on est évidemment limité par des considérations physiques, et notamment par la finesse des motifs que permettent les étapes de photolithographie ; on est limité aussi par les paramètres électriques parasites qui sont dus au processus de fabrication et qui perturbent le fonctionnement de la mémoire.

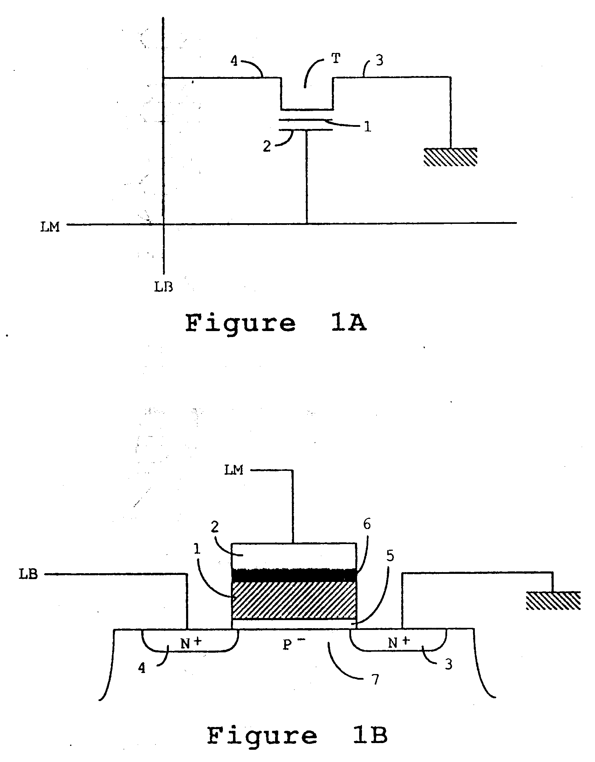

Un point-mémoire élémentaire de mémoire classique est représenté sur les figures 1A et 1B, la figure 1A étant une représentation sous forme de schéma électrique et la figure 1B étant une vue en coupe schématique du point-mémoire élémentaire.

La figure 1A représente un transistor T d'un point-mémoire à grille flottante. Ce transistor possède une grille flottante 1 et une grille de commande 2, ainsi que deux régions semiconductrices d'un premier type de conductivité (source 3 et drain 4) séparées par une région de canal d'un type de conductivité opposé recouverte par la grille flottante 1 et la grille de commande 2.

La grille de commande 2 est reliée à une ligne de mot LM. Le drain 4 est relié à une ligne de bit LB.

Pour programmer, ou écrire, un tel point-mémoire, on charge sa grille flottante 1 par injection de porteurs chauds, en appliquant à la grille de commande 2, pendant que le transistor conduit un courant entre ses régions de source 3, mises à la masse, et de drain 4, un potentiel suffisamment élevé pour que les porteurs de charge (électrons) soient attirés et piégés dans la grille flottante. Cette opération d'écriture a pour effet d'augmenter le seuil de conduction du transistor qui, une fois programmé, ne conduira le courant que pour des valeurs de potentiel appliqué sur la grille de commande plus élevées qu'en l'absence de programmation.

Lors de la lecture de l'information contenue dans un point-mémoire, on applique à la grille de commande du transistor de ce point-mémoire une tension à la fois supérieure à la tension de seuil de déclenchement de conduction à l'état non-programmé et inférieure à la tension de seuil de déclenchement de conduction à l'état programmé. Si le transistor conduit le courant quand une différence de potentiel adaptée est appliquée entre la source et le drain, le point-mémoire est à l'état non-programmé. Si le transistor ne conduit pas le courant, le point-mémoire est à l'état programmé.

Le potentiel appliqué à la grille de commande lorsqu'on programme le point-mémoire, ou potentiel de programmation Vpp, est par exemple de 15 volts. Le potentiel de drain Vcc est alors par exemple de 10 volts, et le potentiel de source Vss est par exemple zéro volt, ou la masse.

Le potentiel appliqué à la grille de commande lors de la lecture du point-mémoire est par exemple de 5 volts. Le potentiel de drain Vcc est alors par exemple de 1,5 volts, et le potentiel de source Vss est par exemple zéro volt, ou la masse.

Sur la figure 1B, qui représente une vue en coupe d'un point-mémoire implanté sur une tranche de silicium, on retrouve la grille flottante 1 et la grille de commande 2 du transistor. On voit également la source 3 et le drain 4, qui sont deux régions semiconductrices d'un premier type de conductivité, par exemple $N^+$, séparées par une région de canal 7 d'un type de conductivité opposé, par exemple $P^-$.

La grille flottante 1 du transistor est réalisée par un premier niveau de silicium polycristallin (poly 1). Elle est séparée du substrat par une couche de dioxyde de silicium 5, également appelée couche d'oxyde de grille.

Au-dessus de la grille flottante 1, on trouve une couche de dioxyde de silicium 6. Cette couche est située entre la grille flottante 1 et la grille de commande 2, cette dernière étant réalisée par un deuxième niveau de silicium polycristallin (poly 2). La couche de dioxyde de silicium 6 porte ainsi également le nom de couche d'oxyde interpoly.

Dans la mémoire, la grille de commande 2 du transistor est reliée à une ligne de mot LM. La source 3 est reliée à la masse, et le drain 4 à une ligne de bit LB.

Avec l'architecture de mémoire classique et le mode de programmation associé, il est impératif que le drain d'un transistor soit électriquement isolé, par de l'oxyde de silicium épais (comparativement à l'oxyde de grille des transistors), du drain des transistors adjacents de la même ligne de mot, faute de quoi on ne pourrait programmer un point-mémoire particulier sans programmer ou déprogrammer en même temps les autres.

Mais cet oxyde épais qui isole deux points adjacents occupe beaucoup de place, surtout lorsqu'il est réalisé par la technique dite d'oxydation localisée.

On a essayé de remplacer l'oxydation localisée par une isolation par tranchées remplies d'oxyde, pour réduire l'encombrement global de la cellule, mais cette technologie n'est pas industriellement au point.

Pour réduire l'encombrement des points-mémoire et ainsi augmenter la capacité de stockage de la mémoire, on a proposé dans la demande de brevet français 86/12940 des structures où les zones d'oxyde épais et les contacts multiples vers les drains ou sources sont supprimés. Ces structures sont appelées structures de type damier.

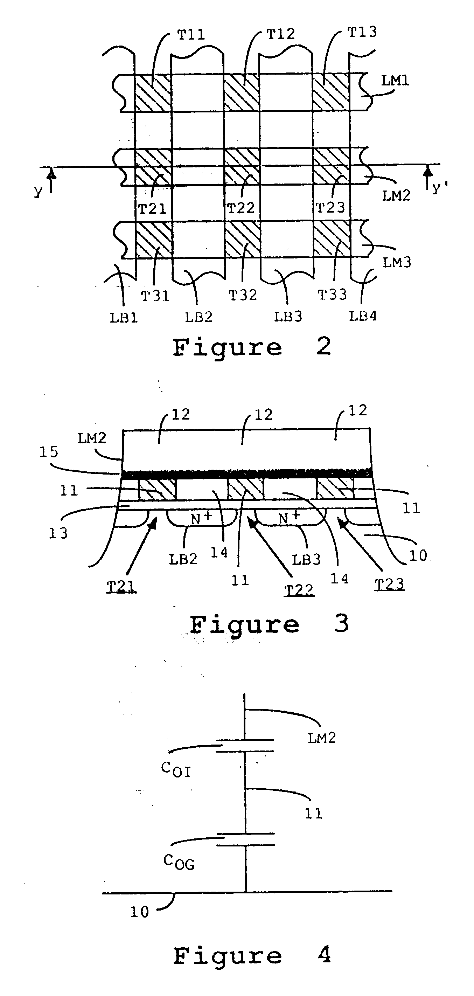

La figure 2 représente une vue de dessus de neuf points-mémoire adjacents dans une telle structure de type damier.

On désigne par Tij les différents transistors à grille flottante constituant le réseau de points-mémoire, où i est un indice de rangée et j un indice de colonne.

Ainsi, les transistors T11 à T13 sont ceux de la première rangée, les transistors T21 à T23 sont ceux de la deuxième rangée, et les transistors T31 à T33 sont ceux de la troisième rangée. De même, les transistors T11 à T31 sont ceux de la première colonne, les transistors T12 à T32 sont ceux de la deuxième colonne et enfin les transistors T13 à T33 sont ceux de la troisième colonne.

Les grilles de commande des transistors d'une même rangée sont toutes reliées à une même ligne de mot, LM1 à LM3 pour les rangées 1 à 3, respectivement.

Les lignes de mot sont des conducteurs (en pratique en silicium polycristallin) s'étendant selon une direction horizontale (direction des rangées).

Chaque transistor partage avec les deux transistors adjacents sur la même rangée une région réalisée par une diffusion du premier type de conductivité qui se prolonge suivant une colonne pour former une ligne de bit, que l'on désigne par LB1, LB2, LB3 et LB4 pour les colonnes 1 à 4, respectivement, et par LBj d'une façon générale. Ces lignes LBj peuvent ainsi faire, à l'emplacement des transistors, soit office de source, soit office de drain.

La figure 3 représente une vue en coupe suivant l'axe YY′ de la figure 2.

Les dispositifs sont situés sur un substrat 10. Les grilles flottantes 11 des transistors sont réalisées par un premier niveau de silicium polycristallin (poly 1) et situées entre deux lignes de bit. Les grilles de commande 12 des transistors sont formées par les parties de la ligne de mot LM2 situées à l'emplacement des transistors. Les lignes de mot, et ainsi les grilles de commande des transistors, sont réalisées par un deuxième niveau de silicium polycristallin (poly 2).

Une couche d'oxyde de grille 13 est située sous la grille flottante des transistors.

Une couche d'oxyde 14 est située entre les grilles flottantes des transistors. De façon classique, un procédé de planarisation est utilisé pour que les surfaces supérieures de cette couche 14 et du premier niveau de silicium polycristallin soient au même niveau. Cette couche 14 est par exemple constituée de tétraéthyle ortho silicate ou TEOS.

Une couche d'oxyde interpoly 15 recouvre les grilles flottantes 11 et les couches d'oxyde 14.

Le mode de programmation de cette architecture est particulier. Il est exposé dans la demande de brevet français précitée. Cela est dû au fait que chaque point-mémoire partage avec chacun des deux points-mémoire adjacents de la même rangée une région qui peut être soit région de source soit région de drain.

Ainsi, la programmation d'un point-mémoire doit tenir compte des points-mémoire adjacents. Cela rend le système d'adressage complexe.

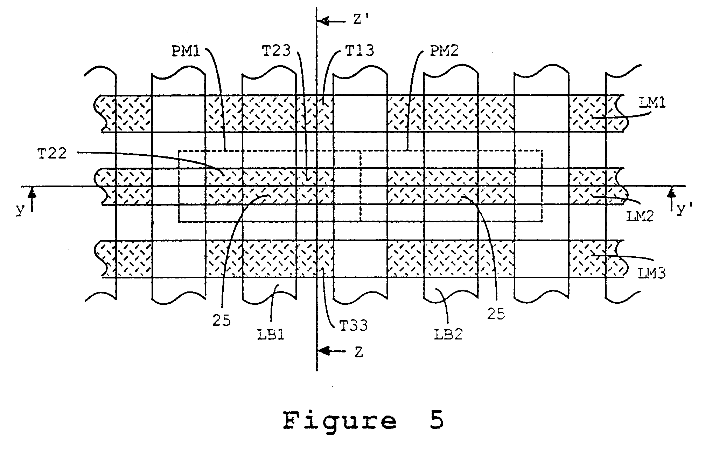

La figure 4 représente un schéma des capacités existant à l'emplacement d'un transistor, par exemple le transistor T22.

Si l'on applique une tension $V_M$ à la ligne de mot LM2, on obtient la tension $V_F$ sur la grille flottante 11 en calculant le facteur de couplage $\gamma$ qui relie ces deux tensions par la relation :

$$V_F = \gamma\, V_M$$

et qui est défini par le rapport entre la capacité au niveau de la couche d'oxyde interpoly et la somme de toutes les capacités présentes.

Si l'on considère la figure 4, on observe la capacité au niveau de la couche d'oxyde interpoly 15 notée $C_{OI}$ et située entre la ligne de mot LM2 et la grille flottante 11. On a aussi une capacité $C_{OG}$ au niveau de la couche d'oxyde de grille 13 située entre la grille flottante 11 et le substrat 10.

Le facteur de couplage $\gamma$ s'écrit :

$$\gamma = C_{OI}/(C_{OI} + C_{OG})$$

On peut calculer une valeur numérique représentative du facteur de couplage en utilisant des valeurs usuelles pour les dimensions des éléments concernés :

- longueur de la grille flottante suivant la direction des rangées : 0,5 micromètre ;
- épaisseur de la couche d'oxyde interpoly : 20 nm ;
- épaisseur de la couche d'oxyde de grille : 20 nm.

La valeur numérique du facteur de couplage est alors égale au rapport entre les quantités 0,5/20 et 0,5/20 + 0,5/20, soit seulement 0,5.

La présente invention propose une nouvelle structure qui permet d'améliorer le facteur de couplage et qui utilise un système d'adressage classique. De plus, cette nouvelle structure ne présente pas de zone d'oxyde épais, ce qui permet à la mémoire d'occuper un encombrement réduit.

Selon l'invention, la mémoire est composée d'un réseau de lignes de mot s'étendant suivant une première direction dite de rangée, et de lignes de bit s'étendant suivant une deuxième direction dite de colonne, dans laquelle chaque point-mémoire est constitué par un couple de transistors MOS à grille flottante, les deux transistors de ce couple ayant une région de drain commune constituée par une diffusion d'un premier type de conductivité qui se prolonge suivant une colonne pour former une ligne de bit dans un substrat du deuxième type de conductivité, chaque transistor d'un couple a une région de source qui est constituée par une diffusion du premier type de conductivité se prolongeant suivant une colonne et qui est située de chaque côté, suivant la direction des rangées, de la région de drain commune, ces régions de source étant toutes reliées à un même potentiel constant et, en outre, dans laquelle une zone conductrice est reliée aux grilles flottantes des deux transistors de chaque couple et est en regard de la ligne de mot connectée au point-mémoire constitué par le couple de transistors et correspondant, à l'emplacement de ce couple, à la grille de commande.

Ces objets, caractéristiques et avantages ainsi que d'autres de la présente invention seront exposés plus en détail dans la description suivante d'un mode de réalisation particulier faite en relation avec les figures jointes parmi lesquelles :

les figures 1A et 1B, déjà décrites, représentent un point-mémoire élémentaire de mémoire classique, la figure 1A étant une représentation sous forme de schéma électrique et la figure 1B étant une vue en coupe schématique du point-mémoire élémentaire ;

la figure 2, déjà décrite, représente une vue de dessus de l'implantation de neuf points-mémoire adjacents sur une tranche de silicium dans une architecture classique de type damier ;

la figure 3, déjà décrite, représente une vue en coupe suivant l'axe YY' de la figure 2 ;

la figure 4, déjà décrite, représente un schéma des capacités existant à l'emplacement d'un transistor dans une architecture telle que celle de la figure 2 ;

la figure 5 représente une vue de dessus d'une structure selon la présente invention ;

la figure 6 représente une vue en coupe suivant l'axe YY' de la figure 5 ;

la figure 7 représente une vue en coupe suivant l'axe ZZ' de la figure 5 ; et

la figure 8 représente un schéma des capacités existant à l'emplacement d'un point-mémoire de la structure de la figure 5.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

La figure 5 représente une vue de dessus d'un mode de réalisation de la structure selon la présente invention. Comme dans le cas de la figure 2, les transistors sont disposés en réseau de rangées et colonnes.

Les grilles de commande des transistors de la rangée i sont encore toutes reliées à des lignes de mot LMi.

Mais dans cette structure, chaque point-mémoire est constitué par un couple de transistors. Deux points-mémoire sont par exemple délimités sur la figure par des traits hachurés et désignés par PM1 et PM2.

Une zone conductrice 25 est reliée aux grilles flottantes des deux transistors de chaque couple. Les lignes de bit LBj ne sont plus situées entre chaque colonne de transistors, mais elles sont séparées par deux colonnes de transistors.

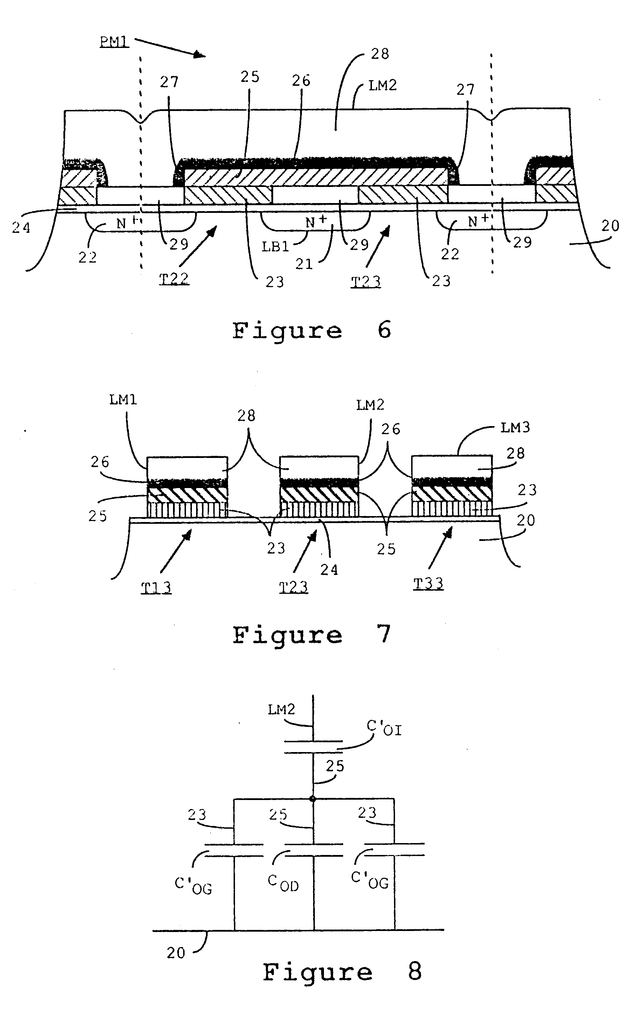

La figure 6 permet d'examiner un point-mémoire suivant une coupe YY' de la figure 5. Ce point-mémoire, par exemple le point-mémoire PM1, est également délimité sur la figure par des traits hachurés.

Les dispositifs sont situés sur un substrat 20. Deux transistors T22 et T23, qui forment un couple de transistors constituant un point-mémoire, partagent une région de drain commune 21. La région de drain commune 21 est constituée par une diffusion d'un premier type de conductivité qui se prolonge suivant une colonne pour former une ligne de bit LB1.

Chacun des deux transistors T22 et T23 comprend une région de source 22 qui est constituée par une diffusion du premier type de conductivité. Ces diffusions se prolongent suivant une colonne et sont situées de chaque côté, suivant la direction des rangées, de la région de drain commune. Chaque région de source est elle-même partagée avec un transistor d'un point-mémoire adjacent de la même rangée.

Les grilles flottantes 23 des transistors sont réalisées par un premier niveau de silicium polycristallin (poly 1). Une couche d'oxyde de grille 24 est située sous les grilles flottantes des transistors. Une zone conductrice 25 est reliée aux grilles flottantes des deux transistors T22 et T23. Elle est réalisée par un deuxième niveau de silicium polycristallin (poly 2). Cette zone conductrice 25 est recouverte sur sa surface supérieure par une couche d'oxyde interpoly 26, et elle est recouverte à ses deux extrémités, suivant la direction des rangées, par une zone d'oxyde 27 qui est appelée zone d'oxyde de coin.

Une couche d'oxyde 29 est située entre les grilles flottantes des transistors. Comme dans le cas de la structure de type damier, un procédé de planarisation est utilisé pour que les surfaces supérieures de cette couche 29 et du premier niveau de silicium polycristallin soient au même niveau. Cette couche 29 est par exemple constituée de TEOS.

La ligne de mot LM2 recouvre l'ensemble.

La couche d'oxyde interpoly 26 et les zones d'oxyde de coin 27 permettent d'isoler la zone conductrice 25 de la ligne de mot LM2. La ligne de mot LM2 fait office de grille de commande 28 à l'emplacement des points-mémoire.

La figure 7 représente une vue en coupe suivant l'axe ZZ' de la figure 5. On retrouve sur cette figure les transistors T13, T23 et T33. Les transistors possèdent chacun une grille flottante 23 située au-dessus de la couche d'oxyde de grille 24. La zone conductrice 25 est placée au-dessus des grilles flottantes 23 et au-dessous de la couche d'oxyde interpoly 26. On observe également les lignes de mot LM1, LM2 et LM3, situées au-dessus des couches d'oxyde interpoly 26, qui font office de grille de commande 28 à l'emplacement des points-mémoire.

La figure 8 représente un schéma des capacités existant à l'emplacement d'un point-mémoire de la structure selon la présente invention. On observe sur cette figure la capacité au niveau de la couche d'oxyde interpoly 26 notée $C'_{OI}$ et située entre la ligne de mot LM2 et la zone conductrice 25. On a aussi une capacité $C'_{OG}$ au niveau de la couche d'oxyde de grille 24 située entre les grilles flottantes 23 et le substrat 20. Cette capacité $C'_{OG}$ apparaît deux fois dans un point-mémoire. Il existe également une capacité $C_{OD}$ au niveau de la couche d'oxyde de type TEOS séparant les grilles flottantes 23.

Le facteur de couplage $\gamma$ s'écrit :

$$\gamma = C'_{OI}/(C'_{OI} + C'_{OG} + C_{OD} + C'_{OG})$$

On peut calculer une valeur numérique représentative du facteur de couplage en utilisant les valeurs usuelles suivantes :
- longueur de la grille flottante suivant la direction des rangées : 0,5 micromètre ;
- longueur de la couche d'oxyde de type TEOS suivant la direction des rangées : 0,6 micromètre ;
- épaisseur de la couche d'oxyde interpoly : 20 nm ;
- épaisseur de la couche d'oxyde de grille : 20 nm ;
- épaisseur de la couche d'oxyde de type TEOS : 200 nm.

La valeur numérique du facteur de couplage est alors égale au rapport entre les quantités (0,5 + 0,6 + 0,5)/20 et (0,5 + 0,6 + 0,5)/20 + 0,5/20 + 0,6/(200 + 20) + 0,5/20.

Le facteur de couplage est alors égal à 0,61.

La structure selon l'invention permet ainsi d'améliorer le facteur de couplage.

Cette structure présente également de bonnes conditions de planarisation du fait de l'absence de zone d'oxyde épais.

Enfin, des lignes conductrices (non représentées sur les figures) constituées par exemple en aluminium sont situées chacune au-dessus d'une ligne de bit. Elles sont connectées à des lignes de bit d'autres blocs mémoire permettant ainsi d'appliquer le potentiel désiré à ces lignes de bit et aux drains des transistors auxquels les lignes de bit sont reliées. Dans le cas de la structure de type damier, une telle ligne conductrice est située entre chaque paire de colonnes de transistors. Dans le cas de la structure selon l'invention, deux colonnes de transistors séparent deux lignes conductrices adjacentes. L'élaboration des lignes conductrices sera ainsi plus facile à réaliser dans le deuxième cas.

## Revendications

1. Mémoire composée d'un réseau de lignes de mot (LM1 à LM3) s'étendant suivant une première direction dite de rangée, et de lignes de bit (LB1 à LB4) s'étendant suivant une deuxième direction dite de colonne, dans laquelle :

   chaque point-mémoire est constitué par un couple de transistors MOS à grille flottante,

   les deux transistors de ce couple ont une région de drain commune (21) constituée par une diffusion d'un premier type de conductivité qui se prolonge suivant une colonne pour former une ligne de bit dans un substrat (20) du deuxième type de conductivité,

   chaque transistor d'un couple a une région de source (22) qui est constituée par une diffusion du premier type de conductivité se prolongeant suivant une colonne et qui est située de chaque côté, suivant la direction des rangées, de la région de drain commune, ces régions de source étant toutes reliées à un même potentiel constant,

   caractérisée en ce qu'une zone conductrice (25) est reliée aux grilles flottantes (23) des deux transistors de chaque couple et est en regard de la ligne de mot connectée au point-mémoire constitué par le couple de transistors, cette ligne de mot correspondant, à l'emplacement de ce couple, à la grille de commande (28).

2. Mémoire selon la revendication 1, caractérisée en ce que, suivant la direction des rangées, une première couche d'oxyde (29) est située entre les grilles flottantes (23) des transistors, et en ce que les dimensions suivant la direction des rangées de la zone conductrice (25) sont sensiblement égales à la somme des dimensions suivant la direction des rangées des grilles flottantes (23) comptées deux fois et de la première couche d'oxyde (29), les dimensions suivant la direction des colonnes de la zone conductrice (25) étant sensiblement égales à celles de la ligne de mot et des grilles flottantes des transistors.

3. Mémoire selon l'une des revendications 1 ou 2, caractérisée en ce que les grilles flottantes (23), les zones conductrices (25) et les lignes de mot (LMi) sont réalisées respectivement par des premier, deuxième et troisième niveaux de silicium polycristallin.

4. Mémoire selon l'une quelconque des revendications 1 à 3, caractérisée en ce que la zone conductrice (25) est recouverte sur sa surface supérieure par une deuxième couche d'oxyde (26) et est recouverte à ses extrémités, suivant la direction des rangées, par une zone d'oxyde de coin (27), pour assurer l'isolation entre ladite zone conductrice (25) et la ligne de mot recouvrant ladite deuxième couche d'oxyde (26) et lesdites zones d'oxyde de coin (27).

5. Procédé de fabrication de mémoire de type MOS à transistors à grille flottante disposés selon des rangées et des colonnes sur un substrat d'un premier type de conductivité, mémoire dans laquelle chaque point-mémoire est constitué par un couple de transistors disposés suivant une rangée, comprenant les étapes suivantes :
   - déposer et graver un premier niveau de silicium polycristallin pour former selon des colonnes des bandes dans lesquelles seront définies ultérieurement les grilles flottantes (23) des transistors,
   - réaliser une implantation du deuxième type de conductivité en utilisant le premier niveau de silicium polycristallin comme masque, pour former des colonnes alternées de drains (21) et de sources (22) desdits transistors,
   - former des bandes d'isolement entre les différentes bandes du premier niveau de silicium polycristallin,
   caractérisé en ce qu'il comprend en outre les étapes suivantes :
   - déposer un deuxième niveau de silicium polycristallin (25) et l'isoler superficiellement (26),
   - graver le deuxième niveau de silicium polycristallin (25) pour qu'il recouvre selon des colonnes les couples de bandes adjacentes à partir desquelles seront formées les grilles flottantes des transistors d'un couple de transistors,
   - isoler latéralement les régions apparentes du deuxième niveau de silicium polycristallin (27),
   - déposer un troisième niveau de silicium polycristallin,
   - graver par un même masque, selon des rangées, les trois niveaux de silicium polycristallin,
   - former une couche isolante, et
   - établir des contacts avec les bandes restantes du troisième niveau de silicium polycristallin (lignes de mot), avec les colonnes de drains (lignes de bit), et avec les colonnes de sources.

6. Procédé de fabrication de mémoire selon la revendication 5, caractérisé en ce que les bandes d'isolement entre les bandes du premier niveau de silicium polycristallin sont réalisées par un procédé de planarisation qui permet d'amener les surfaces supérieures de cette couche (29) et du premier niveau de silicium polycristallin au même niveau.

7. Procédé de fabrication de mémoire selon la revendication 6, caractérisé en ce que les bandes d'isolement sont constituées de tétraéthyle ortho silicate ou TEOS.

**Claims**

1. A memory comprising word lines (LM1-LM3) extending along a first direction (row direction), and bit lines (LB1-LB4) extending along a second direction (column direction), wherein:
   each memory point is made by a pair of floating gate MOS transistors,
   the two transistors of said pair have a common drain region (21) made by a diffusion of a first conductivity type which extends along a column for forming a bit line on a substrate (20) of the second conductivity type,
   each transistor of a pair has a source region (22) which is made by a diffusion of the first conductivity type extending along a column and arranged on each side, along the row direction, of the common drain region, said source regions being interconnected to a same constant potential,
   characterized in that a conductive layer (25) is connected to the floating gates (23) of the two transistors of each pair and is in register with the word line connected to the memory point constituted by the transistor pair, said word line corresponding, at the position of said pair, to the control gate (28).

2. A memory according to claim 1, characterized in that, along the row direction, a first oxide layer (29) is arranged between the floating gates (23) of the transistors, and the size along the row direction of the conductive area (25) is substantially equal to the sum of the sizes along the row direction of the floating gates (23) counted twice and of the first oxide layer (29), the size along the row direction of the conductive area (25) being substantially equal to that of the word line and of the transistor floating gates.

3. A memory according to claim 1 or 2, characterized in that the floating gates (23), the conductive areas (25) and the word lines (LMi) are made by first, second and third polysilicon levels, respectively.

4. A memory according to any of claims 1 to 3, characterized in that the conductive area (25) is covered on its upper surface by a second oxide level (26) and is covered at its extremities, along the row direction, by a corner oxide area (27), for ensuring the isolation between said conductive layer (25) and the word line covering said second oxide layer (26) and said corner oxide areas (27).

5. A method for manufacturing a memory including floating gate MOS transistors arranged according to rows and columns on a substrate of the first conductivity type.; each memory point of this memory being made by a pair of transistors arranged according to a row, comprising the following steps:
   - depositing and etching a first polysilicon level for forming, according to columns, stripes wherein will be subsequently determined the floating gates (23) of the transistors,
   - implanting a dopant of the second conductivity type by using the first polysilicon level as a mask, for forming alternate drain (21) and source (22) columns of said transistors,
   - forming isolation stripes between the various stripes of the first polysilicon level, characterized in that it further comprises:
   - depositing a second polysilicon level (25) and isolating its surfaces (26),
   - etching the second polysilicon level (25) for having it to cover, according to columns, the pairs of adjacent stripes from which will be formed the transistor floating gates of a transistor pair,
   - laterally isolating the apparent regions of the second polysilicon level (27),
   - depositing a third polysilicon level,
   - etching by a same mask, according to rows, the three polysilicon levels,
   - forming an isolating layer, and
   - establishing contacts with the remaining stripes of the third polysilicon level (word lines), with the drain columns (bit lines) and with the source columns.

6. A manufacturing method according to claim 5, characterized in that the isolation stripes between the stripes of the first polysilicon level are made by a planarization process which permits to position the upper surfaces of said stripe (29) and the upper surfaces of the first polysilicon level at the same level.

7. A manufacturing method according to claim 6, characterized in that the isolation stripes are made of tetraethyl ortho silicate (TEOS).

**Patentansprüche**

1. Speicher mit einem Netz aus Wortleitungen (LM1 bis LM3), die sich in einer ersten Richtung in Zeilen erstrecken, und aus Bit-Leitungen (LB1 bis LB4), die sich in einer zweiten Richtung in Spalten erstrecken, wobei:
   jeder Speicherpunkt durch ein MOS-Transistorpaar mit schwebendem Gitter gebildet ist,
   die beiden Transistoren dieses Paares einen gemeinsamen Drain-Bereich (21) aufweisen, der durch Diffusion eines Materiales eines ersten Leitungstypes, das sich längs einer Spalte erstreckt, gebildet ist, um eine Bit-Leitung in einem Substrat (20) von einem zweiten Leitungstyp zu bilden,
   jeder Transistor eines Paares einen Source-Bereich (22) aufweist, der durch Diffusion eines Materiales von einem ersten Leitungstyp gebildet ist, das sich längs einer Spalte erstreckt und längs der Richtung der Zeilen zu beiden Seiten des gemeinsamen Drain-Bereichs gelegen ist, wobei die Source-Bereiche sämtlich an ein gemeinsames konstantes Potential angeschlossen sind,
   dadurch gekennzeichnet, daß eine leitende Zone (25) an die schwebenden Gitter (23) der beiden Transistoren jedes Paares angeschlossen ist und in bezug auf eine Wortleitung mit dem Speicherpunkt verbunden ist, der durch das Transistorpaar gebildet wird, wobei diese Wortleitung am Ort des Paares dem Steuergitter (28) entspricht.

2. Speicher nach Anspruch 1, dadurch gekennzeichnet, daß längs der Richtung der Zeilen eine erste Oxidschicht (29) zwischen den schwebenden Gittern (23) der Transistoren gelegen ist, und daß die Dimensionen der leitenden Zone (25) in Richtung der Zeilen gleich der Summe der zweifachen Dimension der schwebenden Gitter (23) in Zeilenrichtung und der ersten Oxidschicht (29) sind, wobei die Dimensionen der leitenden Zone (25) in Spaltenrichtung gleich derjenigen der Wortreihe und der schwebenden Gitter der Transistoren sind.

3. Speicher nach einem der Ansprüche 1 oder 2, dadurch gekennzeichnet, daß die schwebenden Gitter (23) die leitenden Zonen (25) und die Wortleitungen (LMi) jeweils durch ein erstes, zweites bzw. drittes Niveau aus polykristallinem Silizium realisiert sind.

4. Speicher nach einem der Ansprüche 1 bis 3, dadurch gekennzeichnet, daß die leitende Zone (25) an ihrer Oberseite durch eine zweite Oxidschicht (26) und an ihren äußeren Rändern in Zeilenrichtung durch eine Kantenoxidzone (27) bedeckt ist, um die Isolierung zwischen der leitenden Zone (25) und der Wortleitung sicherzustellen, die die zweite Oxidschicht (26) und die genannten Kantenoxidzonen (27) bedeckt.

5. Verfahren zur Herstellung eines MOS-Speichertyps mit Transistoren mit schwebendem Gitter, die längs Zeilen und Spalten auf einem Substrat eines ersten Leitungstyps angeordnet sind, wobei in dem Speicher jeder Speicherpunkt durch ein Paar von Transistoren gebildet wird, die längs einer Zeile angeordnet sind, mit folgenden Verfahrensschritten:
   - Abscheiden und Ätzen einer ersten polykristallinen Siliziumschicht, um längs der Spalten Bänder zu bilden, in denen letztlich die schwebenden Gitter (23) der Transistoren angeordnet werden,
   - Implantieren eines Materials von einem zweiten Leitungstyp, indem die erste Schicht aus polykristallinem Silizium als Maske verwendet wird, um abwechselnd Spalten von Drain-Bereichen (21) und Source-Bereichen (22) dieser Transistoren zu formen,
   - Formen von Isolierbändern zwischen den unterschiedlichen Bändern der ersten Schicht aus polykristallinem Silizium,
   dadurch gekennzeichnet, daß darüberhinaus die folgenden Verfahrensschritte vorgesehen sind:
   - Ablagern einer zweiten Schicht (25) aus polykristallinem Silizium und Isolieren von deren Oberfläche (26),
   - Ätzen der zweiten Schicht aus polykristallinem Silizium (25), damit sie längs der Spalten die Paare benachbarter Bänder bedeckt, von denen ausgehend die schwebenden Gitter der Transistoren eines Transistorpaares gebildet werden,
   - Isolieren der freiliegenden seitlichen Bereiche der zweiten Schicht aus polykristallinem Silizium (27),
   - Abscheiden einer dritten Schicht aus polykristallinem Silizium,
   - Ätzen der drei Schichten des polykristallinen Siliziums mit einer Maske längs der Zeilen,
   - Bilden einer Isolierschicht, und
   - Einrichten von Kontakten zwischen den verbleibenden Bändern der dritten Schicht des polykristallinen Siliziums (Wortleitungen) und den Drain-Spalten (Bit-Leitungen) sowie den Source-Spalten.

6. Verfahren zum Herstellen eines Speichers nach Anspruch 5, dadurch gekennzeichnet, daß die Isolierbänder zwischen den Bändern der ersten Schicht aus polykristallinem Silizium durch ein Planarverfahren realisiert werden, das es gestattet, die Oberflächen dieser Schicht (29) und der ersten Schicht aus polykristallinem Silizium auf gleichem Niveau auszuführen.

7. Verfahren zum Herstellen eines Speichers nach Anspruch 6, dadurch gekennzeichnet, daß die Isolierbänder aus Tetraethylorthosilikat, d.h. TEOS bestehen.

Figure 1A

Figure 1B

Figure 2

Figure 3

Figure 4

Figure 5

PM1

Figure 6

Figure 7

Figure 8